# FASCICULE DE BREVET EUROPEEN

(11) **EP 3 776 661 B1**
(45) Date de publication et mention de la délivrance du brevet: **15.07.2026**
(21) Numéro de dépôt: 19722162.5
(22) Date de dépôt: 04.04.2019
(51) Int. Cl.: H10K 59/122

(54) **DISPOSITIF ÉLECTROLUMINESCENT À RÉSOLUTION ET FIABILITÉ AMÉLIORÉES**
ELEKTROLUMINESZENTE VORRICHTUNG MIT VERBESSERTER AUFLÖSUNG UND ZUVERLÄSSIGKEIT
ELECTROLUMINESCENT DEVICE WITH IMPROVED RESOLUTION AND RELIABILITY

(30) Priorité: 05.04.2018 FR 1852948
(43) Date de publication de la demande: 17.02.2021
(73) Titulaire: Microoled, 38000 Grenoble Cedex 9 (FR)
(72) Inventeur: HAAS, Gunther, 38120 SAINT-EGREVE (FR); GUILLAMET, Sébastien, 35136 SAINT-JACQUES-DE-LA-LANDE (FR); THOMSCHKE, Michael, 38120 SAINT-EGREVE (FR); BONNET, Robin, 38000 GRENOBLE (FR)
(74) Mandataire: IXAS Conseil
(86) Numéro de dépôt international: PCT/FR2019/050791
(87) Numéro de publication internationale: WO 2019/193290

(56) Documents cités:
- EP-A1- 3 301 548
- CN-A- 106 783 924
- CN-A- 107 346 778
- FR-A1- 2 992 098
- US-A1- 2014 103 385
- US-A1- 2016 181 331

## Description

### Domaine technique de l'invention

L'invention se rattache au domaine des dispositifs et composants optoélectroniques, et plus précisément aux dispositifs électroluminescents de type OLED (Organic Light Emitting Device). Elle concerne plus particulièrement l'amélioration de la fiabilité de la gamme de couleur d'affichage ainsi que de la résolution d'un écran d'affichage de type OLED. Elle concerne aussi bien les dispositifs OLED simples que les dispositifs OLED de type tandem.

### Etat de la technique

Les dispositifs électroluminescents organiques (OLED, « Organic Electroluminescent Device ») suscitent un intérêt considérable dans les systèmes d'éclairage à écran plat et les écrans minces. La durée de vie opérationnelle des dispositifs OLED diminue avec l'augmentation de la densité de courant ou de la luminance car le grand nombre de trous et d'électrons traversant la couche organique provoque des réactions secondaires électrochimiques des composés organiques. Une approche particulière pour résoudre ce problème est l'utilisation de deux ou plusieurs diodes OLED superposées (dispositifs dits en « tandem »), qui vise à atteindre une durée de fonctionnement plus longue sous haute luminance. Dans une structure OLED en tandem, plusieurs unités électroluminescentes sont empilées en série à travers des couches d'interconnexion telles qu'une couche conductrice transparente (TCL, « Transparent Conductive Layer ») ou une couche de génération de charge (CGL, « Charge Generation Layer »). De plus, les couches d'injection d'électrons (EIL, « Electron Injection Layer »)) jouent également un rôle important pour réduire la barrière d'injection d'électrons du TCL ou du CGL dans la première unité électroluminescente. Avec une densité de courant identique, comparée à un seul dispositif électroluminescent, les OLED en tandem avec deux unités électroluminescentes superposées peuvent présenter une luminance double. Par conséquent, l'efficacité et la durée de vie opérationnelle des OLED en tandem peuvent être améliorées par rapport à celles des OLED conventionnelles à une seule unité.

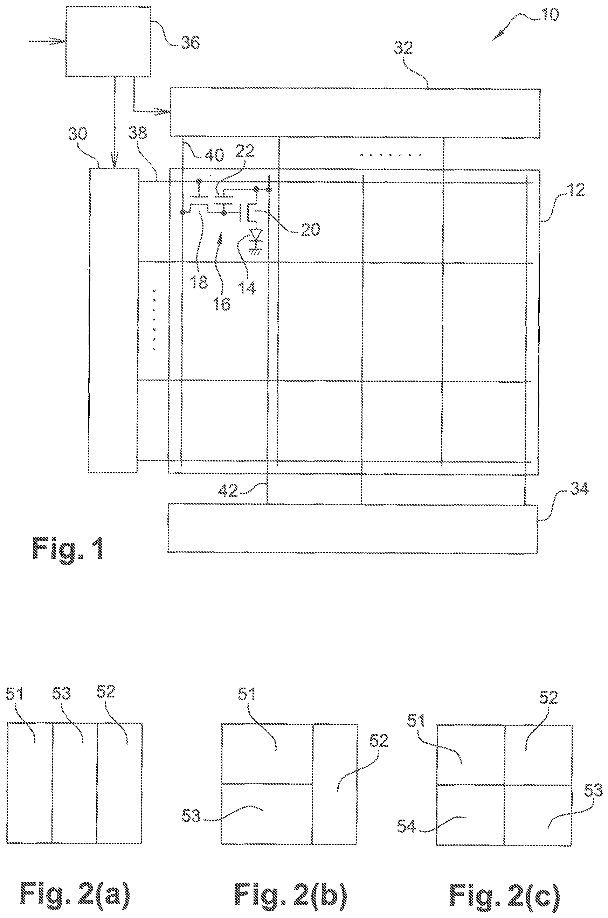

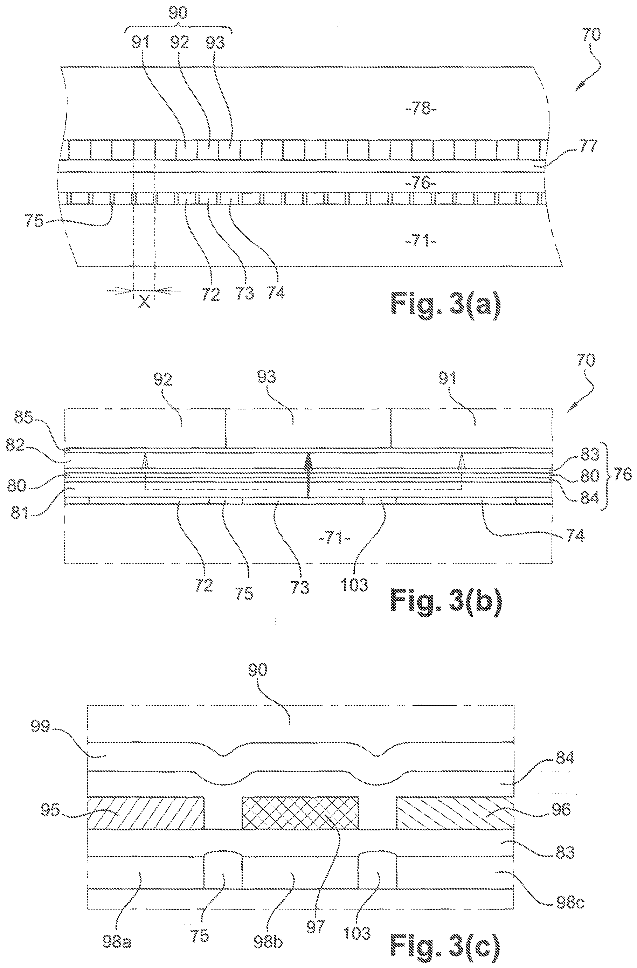

Les écrans d'affichage OLED comprennent en général une structure matricielle de pixels individuels, qui est contrôlée par une grille de pistes conductrices verticales et horizontales ; cette structure peut permettre un adressage individuel des pixels. Cela est illustré de manière schématique sur la figure 1 qui sera expliquée ci-dessous. Dans les écrans couleur chaque pixel est subdivisé en sous-pixels de différentes couleurs (typiquement trois ou quatre, dont le rouge, le vert et le bleu) qui coopèrent pour émettre un point lumineux (pixel) de couleur voulue. La figure 3(a) montre une section d'un tel écran. Au-dessus des électrodes des sous-pixels est déposé un empilement OLED qui couvre toute la surface de la matrice et qui (dans cet exemple) émet de la lumière blanche. Les primaires RGB (Red-Green-Blue) ou RGBW (Red-Green-Blue-White) des sous pixels sont dans ce cas générés par des filtres colorés situées au-dessus de l'empilement OLED. Une autre façon de façon de réaliser les couleurs primaires est de structurer les couches OLED en sous-pixel avec des couleurs d'émission différentes. Comme le procédé de structuration des couches OLED est assez complexe et la résolution atteignable assez limitée, on préfère même dans ce cas garder un maximum de couches communes (i.e. des couches couvrant toute la surface de la matrice), en général les couches des transports des porteurs de charges, et de ne structurer que les couches émettrices. Cependant, dans les deux cas précédents, on observe que les pixels ou sous-pixels voisins peuvent interagir, par couplage capacitif ou par des courants parasites passant notamment à travers des couches conductrices communes de l'empilement OLED.

Un exemple pour ce courant parasite est illustré sur la figure 3(b) qui sera expliquée ci-dessous. Cette interaction indésirable entre des pixels voisins est connue de l'homme du métier sous le nom « crosstalk » (diaphonie) ; elle conduit surtout à la modification indésirable des couleurs dans le cas des écrans couleur. Les aspects théoriques du phénomène de crosstalk dans les dispositifs OLED ont été étudiés depuis longtemps (voir par exemple la publication de D. Braun « Crosstalk in passive matrix polymer LED displays » parue en 1998 dans la revue Synthetic Metals 92, p. 107-113).

Bien connu dans le cas de dispositifs OLED à diodes simples, le phénomène de crosstalk est exacerbé dans les dispositifs OLED à diodes tandem. Les couches d'interconnexion des structures superposées en tandem présentent une conductivité électrique assez élevée, et on observe des courants parasites dans le plan des couches. Ce problème devient plus perceptible lorsque la taille du sous-pixel diminue. Hormis la correction numérique des conséquences du crosstalk (qui revient à accepter le phénomène de crosstalk et de diminuer son impact sur l'image), on connaît différentes approches pour lutter contre le crosstalk à la source, c'est-à-dire pour diminuer le phénomène physique au niveau du pixel ou sous-pixel.

Pour un dispositif OLED simple, il est connu de séparer chaque pixel pour les isoler les uns des autres pour éviter les problèmes de court-circuit liés à l'humidité dans les couches d'encapsulation. Le document EP 2 927 985 décrit une structure dans laquelle chaque pixel est hermétiquement scellé et isolé de ses pixels voisins. La fabrication d'une telle structure nécessite des étapes de procédé nombreuses et complexes. Il est également connu de délimiter les zones de pixel par des éléments séparateurs supplémentaires, tels que des murs, comme décrit dans le document US 9 419 245. Ces procédés sont complexes et engendrent un surcoût significatif. Les documents CN 197346778 A, US 2014/103385 A1, CN 106783924 A, EP 3301548 A1, US 2016/181331 A1 et FR 2992098 A1 décrivent les dispositifs OLED avec des séparateurs différents entre deux pixels voisins.

Compte tenu de ce qui précède, un objectif de la présente invention est de remédier, au moins partiellement, aux inconvénients de l'art antérieur évoqués ci-dessus, et de proposer une architecture pour dispositif d'affichage OLED qui permet de réduire de manière significative les courants parasites latéraux, même pour des pixels de très petite taille (typiquement inférieure à 5 µm), pour des structure à espace inter-pixel très faible, ou pour des afficheurs à diodes tandem.

Un autre objectif de l'invention est de proposer un procédé qui permet de limiter les courants parasites entre les pixels pour un dispositif électroluminescent miniature.

### Objet de l'invention

L'invention s'applique à un dispositif d'affichage électroluminescent comprenant une pluralité de pixels déposés sur un substrat, chaque pixel étant formé d'une ou plusieurs zones émettrices élémentaires, dans lequel chaque zone émettrice élémentaire comporte une électrode de base déposée ledit substrat et une couche électroluminescente déposée sur ladite électrode de base, et ledit dispositif comprenant une électrode commune déposée au-dessus de ladite couche électroluminescente. L'invention est caractérisée par la revendication 1.

Selon un exemple non conforme à l'invention revendiquée, deux électrodes de base voisines appartenant à deux zones émettrices élémentaires voisines sont séparées par un élément de remplissage à surface isolante qui remplit la zone entre lesdites électrodes de base voisines et qui les isole électriquement l'une de l'autre.

Au moins la surface dudit élément de remplissage à surface isolante qui est contact avec lesdites électrodes de base est réalisée en une matière isolante ; l'ensemble dudit élément de remplissage à surface isolante peut être réalisé en matière isolante.

Selon un autre exemple non conforme à l'invention revendiquée, ledit élément de remplissage déborde avec sa matière isolante sur une partie de la surface desdites électrodes de base.

Selon encore une autre caractéristique de l'invention un séparateur se trouve au-dessus dudit élément de remplissage et sépare les couches électroluminescentes de deux zones émettrices élémentaires voisines ; cela élimine les courants de fuite qui se propagent horizontalement au substrat dans les couches électroluminescentes.

Une partie de ladite électrode commune est déposée par une technique de dépôt conforme, de préférence par ALD (Atomic Layer Deposition).

Selon un autre exemple non conforme à l'invention revendiquée un dispositif d'affichage électroluminescent comprenant une pluralité de pixels déposés sur un substrat, chaque pixel étant formé d'une ou plusieurs zones émettrices élémentaires, chaque zone émettrice élémentaire comportant une électrode de base déposée sur ledit substrat et un empilement OLED comprenant une couche électroluminescente déposé sur ladite électrode de base. Ledit dispositif d'affichage électroluminescent comprend une électrode commune déposée au-dessus dudit empilement OLED. Il est caractérisé en ce que :
- deux électrodes de base voisines appartenant à deux zones émettrices élémentaires voisines sont séparées par un élément de remplissage à surface isolante qui remplit la zone entre lesdites électrodes de base voisines et qui les isole électriquement l'une de l'autre,
- au moins la surface dudit élément de remplissage à surface isolante qui est contact avec lesdites électrodes de base est réalisée en une matière isolante ;
- Un séparateur se trouve au-dessus dudit élément de remplissage et sépare les couches électroluminescentes de l'empilement OLED de deux zones émettrices élémentaires voisines.

Ladite électrode commune est avantageusement déposée par une technique de dépôt conforme, de préférence par ALD (Atomic Layer Deposition) ou CVD (Chemical Vapor Deposition) afin d'obtenir une continuité au travers des séparateurs. Les couches de l'empilement OLED sont avantageusement déposées par une technique de dépôt directive (i.e. non conforme), telle que l'évaporation thermique, afin de pouvoir les séparer par le séparateur.

Avantageusement, ledit élément de remplissage déborde avec sa matière isolante sur une partie de la surface desdites électrodes de base ;
Dans un mode de réalisation, entre deux séparateurs voisins, et délimitée par ces derniers, s'étend une électrode supérieure, déposée entre ledit empilement OLED et ladite électrode commune. Cette électrode supérieure ne présente pas d'avantage fonctionnel ; au contraire, dans le cas d'un dispositif de type émission vers le haut, elle absorbe de la lumière. Elle peut être utile pour protéger l'empilement OLED lors du dépôt de l'électrode commune.

Dans un mode de réalisation avantageux cette électrode supérieure est absente, et c'est l'électrode commune qui remplit la fonction d'électrode pour chaque zone émettrice élémentaire, c'est-à-dire la fonction de cathode pour un dispositif à émission par le haut, ou d'anode pour un dispositif inverse.

Dans un mode de réalisation, entre deux séparateurs voisins, et délimitée par ces derniers, s'étend une couche d'injection de porteurs de charge, déposée entre ledit empilement OLED et ladite électrode commune. Cette couche d'injection de porteurs de charge est capable d'injecter des porteurs de charge dans l'empilement OLED (des électrons dans le cas d'un dispositif OLED dit standard, ou des trous dans le cas d'un dispositif OLED dit inverse, ces termes « standard » et « inverse » étant définis ci-dessous), et elle est capable de protéger l'empilement OLED lors du dépôt de l'électrode commune. Cette couche d'injection de porteurs de charge peut notamment être en oxyde de molybdène ou en oxyde de tungstène, avec une épaisseur préférée entre 0,5 nm et 5 nm.

Nous rappelons ici que l'homme du métier appelle un dispositif OLED « standard » un dispositif OLED dans lequel l'injection des trous se fait sur la face proche du substrat et l'injection des électrons sur la face opposée au substrat, alors que dans un dispositif dit « inverse » ce sont des électrons que l'on injecte sur la face proche du substrat, et des trous sur la face opposée au substrat.

Dans un autre mode de réalisation ledit élément de remplissage à surface isolante et ledit séparateur constituent un élément de barrière qui s'étend en hauteur à partir du substrat. Ledit séparateur peut remplir une partie supérieure de la zone entre lesdites électrodes de base voisines.

Dans encore un autre mode de réalisation tout l'élément de remplissage à surface isolante est réalisé en un matériau isolant. Ledit séparateur peut comprendre ladite électrode commune.

Ces modes de réalisation peuvent être combinés les uns avec les autres.

Dans tous ces modes de réalisation le dispositif d'affichage peut comprend un système d'encapsulation déposé au-dessus de l'électrode commune. Ledit système d'encapsulation peut comprendre une couche de polymère et une couche inorganique, de préférence un oxyde. Il peut comprendre une couche inorganique, de préférence un oxyde, déposé entre l'électrode commune et la couche de polymère. Il peut comprendre une couche de lissage déposée, soit au-dessus de ladite électrode commune, soit au-dessus dudit système d'encapsulation.

Ledit dispositif d'affichage OLED selon l'invention peut comprendre un système de filtres colorés, déposé sur l'électrode commune, ou de préférence sur le système d'encapsulation, ou encore plus préférentiellement sur ladite couche de lissage.

Le dispositif d'affichage selon l'invention peut comprendre deux empilements OLED superposés, qui sont alors typiquement séparés par une couche de génération de charges.

Un autre exemple non conforme à l'invention revendiquée décrit un dispositif d'affichage électroluminescent comprenant une pluralité de pixels déposés sur un substrat, chaque pixel étant formé d'une ou plusieurs zones émettrices élémentaires, chaque zone émettrice élémentaire comportant une électrode de base déposée sur ledit substrat et un empilement OLED comprenant une couche électroluminescente déposé sur ladite électrode de base. Ledit dispositif d'affichage électroluminescent comprend une électrode commune déposée au-dessus dudit empilement OLED. Il est caractérisé en ce que :
- Deux électrodes de base voisines appartenant à deux zones émettrices élémentaires voisines sont séparées par un élément de remplissage à surface isolante qui remplit la zone entre lesdites électrodes de base voisines et qui les isole électriquement l'une de l'autre,
- Au moins la surface dudit élément de remplissage à surface isolante qui est contact avec lesdites électrodes de base est réalisée en une matière isolante ;
- Un séparateur se trouve au-dessus dudit élément de remplissage, sépare les couches électroluminescentes de l'empilement OLED de deux zones émettrices élémentaires voisines, et remplit une partie supérieure de la zone entre lesdites électrodes de base voisines.

Ledit élément de remplissage à surface isolante comprend typiquement une couche d'isolation en contact avec les électrodes de base voisines, capable de les isoler électriquement l'une de l'autre ; il peut comprendre d'autres couches fonctionnelles, telles que l'électrode commune. Le séparateur qui s'étend dans l'espace naturel (qui a typiquement la forme d'une tranchée) entre deux zones émettrices élémentaires voisines comprend typiquement la couche de lissage (couche de planarisation) déposée au-dessus de l'électrode commune ; si cette couche de lissage est absente il peut comprendre un espace vide (i.e. de l'air).

Ces modes de réalisation peuvent être combinés les uns avec les autres.

Ladite électrode commune est avantageusement déposée par une technique de dépôt conforme, de préférence par ALD ou CVD. Avantageusement, ledit élément de remplissage déborde avec sa matière isolante sur une partie de la surface desdites électrodes de base. Les couches de l'empilement OLED sont déposées par une technique de dépôt directive, par exemple par évaporation thermique.

Dans un mode de réalisation, entre deux séparateurs voisins, et délimitée par ces derniers, s'étend une électrode supérieure, déposée entre ledit empilement OLED et ladite électrode commune. Elle peut être utile pour protéger l'empilement OLED lors du dépôt de l'électrode commune. Elle peut être absente, et c'est l'électrode commune qui remplit la fonction d'électrode pour chaque zone émettrice élémentaire, c'est-à-dire la fonction de cathode pour un dispositif di standard, ou d'anode pour un dispositif inverse. Dans une variante de ce mode de réalisation, entre deux séparateurs voisins, et délimitée par ces derniers, s'étend une couche d'injection de porteurs de charge, déposée entre ledit empilement OLED et ladite électrode commune. Cette couche d'injection de porteurs de charge est capable d'injecter des porteurs de charge dans l'empilement OLED (des électrons dans le cas d'un dispositif OLED de type émission par le haut, ou des trous dans le cas d'un dispositif OLED dit inverse), et elle est capable de protéger l'empilement OLED lors du dépôt de l'électrode commune. Cette couche d'injection de porteurs de charge peut notamment être en oxyde de molybdène ou en oxyde de tungstène, avec une épaisseur préférée entre 0,5 nm et 5 nm.

Dans tous ces modes de réalisation le dispositif d'affichage peut comprend un système d'encapsulation déposé au-dessus de l'électrode commune. Ledit système d'encapsulation peut comprendre une couche de polymère et une couche inorganique, de préférence un oxyde. Il peut comprendre une couche inorganique, de préférence un oxyde, déposé entre l'électrode commune et la couche de polymère. Il peut comprendre une couche de lissage déposée, soit au-dessus de ladite électrode commune, soit au-dessus dudit système d'encapsulation.

Ledit dispositif d'affichage OLED selon l'invention peut comprendre un système de filtres colorés, déposé sur l'électrode commune, ou de préférence sur le système d'encapsulation, ou encore plus préférentiellement sur ladite couche de lissage.

Le dispositif d'affichage selon l'invention peut comprendre deux empilements OLED superposés, qui sont alors typiquement séparés par une couche de génération de charges.

### Description des figures

Les figures 1 à 3 illustrent des aspects généraux, connus, des dispositifs et afficheurs OLED. Les figures 4 à 8 illustrent des aspects et modes de réalisation de l'invention ; elles n'ont pas pour vocation de limiter la portée de l'invention.
La figure 1 montre le schéma électrique d'un écran matriciel de type OLED de type connu. La figure 2 montre trois exemples connus de disposition de sous-pixels de couleurs différentes pour former un pixel capable d'afficher la couleur voulue.
La figure 3 montre de manière schématique une coupe transversale perpendiculaire d'un pixel dans un afficheur OLED selon l'état de la technique avec un OLED à émission blanche et des filtres de couleur. La figure 3(a) montre plusieurs pixels ; la figure 3(b) montre un seul pixel avec trois sous-pixels. La figure 3(c) montre un mode de réalisation d'un pixel de couleur sans filtres de couleur.
La figure 4 est une vue en coupe illustrant un dispositif suivant un exemple non conforme à l'invention revendiquée.
La figure 5 est une vue en coupe illustrant un dispositif structure suivant un mode de réalisation de l'invention.
La figure 6 montre de manière schématique une coupe transversale perpendiculaire d'un dispositif de type tandem selon un autre exemple non conforme à l'invention revendiquée: la figure 6(b) montre de manière schématique un détail de la figure 6(a), à savoir l'empilement de couches organiques formant la couche OLED. La figure 6(c) montre une variante, la figure 6(d) montre de manière schématique l'empilement des couches OLED au-dessus du séparateur dans cette variante.
Les figures 7 et 8 montent des variantes des dispositifs montrés, respectivement, sur les figures 4 et 5.

Les références numériques suivantes sont utilisées dans la présente description:

| | | | |
|---|---|---|---|
| 10 | Afficheur OLED (de type connu) | 12 | Matrice de pixels |
| 14 | Diode OLED | 16 | Circuit de commande de 12 |
| 18 | Transistor à effet de champ | 20 | Transistor à effet de champ |
| 22 | Condensateur | 30 | Circuit de commande pour lignes |
| 32 | Circuit de commande vidéo | 36 | Unité de contrôle |
| 34 | Circuit d'alimentation pour colonnes | 38 | Piste conductrice pour lignes |
| | | 40 | Piste conductrice (signal vidéo) |
| 42 | Piste conductrice pour colonnes | 50 | Pixel |
| 51 | Sous-pixel rouge | 52 | Sous-pixel bleu |
| 53 | Sous-pixel vert | 54 | Sous-pixel blanc |
| 70 | Afficheur OLED (de type connu) | 71 | Substrat |
| 75 | Elément de remplissage (gap-fill) | 72,73, 74 | Electrode de commande de sous-pixel |
| 76 | Couches OLED | | |
| 77 | Couche d'encapsulation | 80 | Couche électroluminescente de 76 |
| 81,82 | Couche d'injection et de transport de charges | 83 | Couche d'injection et de transport de charges |
| 84 | Couche d'injection et de transport de charges | 85 | Electrode |
| | | 90 | Pixel |
| 91 | Filtre bleu pour sous-pixel | 92 | Filtre rouge pour sous-pixel |
| 93 | Filtre vert pour sous-pixel | 98 | Electrode pour pixel |
| 95,96, 97 | Couches éléctroluminescentes Rouge, Vert, Bleu | 99 | Electrode commune |
| 100 | Dispositif selon l'invention | 102 | Electrode de base pour chaque sous-pixel |
| 103 | Elément de remplissage à surface isolante | 104 | Séparateur |
| | | 105 | Empilement OLED |
| 107 | Electrode conforme commune | 106 | Couche d'injection supérieure (optionnelle) |
| 109 | Filtre coloré | 110 | Substrat |
| 108 | Couche de planarisation (lissage) | 111 | Espace naturel (« gap ») |
| | | 112 | Rebord de 103 sur 102 |
| 120 | Pixel | 121 | Sous-pixels |
| 130 | Dispositif tandem selon l'invention | 131 | Premier empilement OLED |
| | | 133 | Deuxième empilement OLED |
| 132 | Couche de génération de charges | 1311, 1331 | Couche d'injection et de transport d'électrons de 131 ou 133 |
| 1312, 1332 | Couche électroluminescente (ou émettrice) de 131 ou 133 | 1313, 1333 | Couche d'injection et de transport de trous de 131 ou 133 |
| 140 | Empilement sur séparateur 104 | 141, 143 | Premier et deuxième empilement sur séparateur 104 |
| | | | |
| 200 | Dispositif selon l'invention | 201 | Sous-pixels |
| 202 | Electrode de commande de sous-pixel | 203 | Elément de remplissage à surface isolante |
| 204 | Séparateur | 205 | Empilement OLED |
| 206 | Couche d'injection supérieure (optionnelle) | 207 | Electrode conforme commune |
| | | 209 | Filtre coloré |
| 208 | Couche de lissage | 211 | Espace naturel (« gap ») entre électrodes 202 |
| 210 | Substrat | | |
| 212 | Rebord de 203 sur 202 | 213 | Pixel |
| 221 | Couche de polymère | 220 | Système d'encapsulation |
| 223 | Couche d'isolant | 222 | Couche d'oxyde |

### Description détaillée

La figure 1 montre de manière schématique le circuit d'un afficheur OLED **10** de type connu qui comprend une unité de matrice de pixels **12** capable de produire une image, et une unité de commande **36.** Les diodes OLED **14** et leurs circuits de commande **16** sont disposés de manière à former des pixels dans l'unité de matrice de pixels **12,** ladite matrice de pixels comportant des lignes (horizontales) et des colonnes (verticales). Chaque circuit de commande **16** d'un pixel **12** comprend une pluralité de transistors en couche mince **18,20** (typiquement en technologie CMOS (Complementary Metal Oxyde Semiconductor) ou TFT (« Thin Film Transistor »)) et un condensateur **22.** L'unité de commande **36** commande un circuit de commande pour les lignes **30** et un circuit d'adressage vidéo **32,** ainsi qu'un circuit d'alimentation électrique **34** pour l'adressage des colonnes de pixel ; elle assure l'adressage des circuits de pixel **36** et contrôle l'émission lumineuse des diodes OLED **14.** Le circuit de commande des lignes est relié aux pistes conductrices **38** adressant les lignes de balayage de la matrice de pixel. Il sélectionne les lignes de balayage **38** selon un signal en provenance de l'unité de contrôle **36,** et applique une tension pour allumer les TFT **18** se trouvant sur la ligne de balayage **38** sélectionnée. Le circuit d'adressage vidéo **32** est relié à des pistes conductrices **40** adressant les colonnes du signal vidéo. Le circuit d'adressage vidéo **32** reçoit un signal vidéo de l'unité de contrôle **36** et envoie une tension sur les pistes conducteurs vidéo **40** des colonnes selon les pistes conductrices des lignes sélectionnées par le du circuit de commande **30** correspondant. Ce signal de tension est inscrit dans le condensateur **32** à travers le TFT **18** de la diode OLED **14** de la ligne de pixel sélectionnée. Le TFT **20** de commande envoie un courant correspondant à la tension enregistrée à la diode OLED **14,** et de ce fait la diode OLED **14** de la ligne sélectionnée **38** émet de la lumière.

Le circuit d'alimentation électrique **34** est relié aux pistes conductrices d'alimentation **42** des colonnes de pixel ; il alimente les diodes OLED **14** par l'intermédiaire des pistes conductrices **32** et des TFT **20** de la ligne de pixels sélectionnée.

Ce principe d'adressage d'une diode OLED formant un pixel dans une matrice de pixels, connu en tant que tel, peut être appliqué, de manière également connue en tant que telle, à l'adressage d'une diode OLED formant un sous-pixel dans une matrice de pixels d'un dispositif d'affichage à couleurs, dans lequel chaque pixel comprend une pluralité de sous-pixels (le plus souvent trois ou quatre) de couleurs différentes ; cela sera expliqué ici en relation avec la figure 2. Les figures 2(a), (b) et (c) montrent trois exemples pour la disposition géométrique de ces sous-pixels **51,52,53,54** pour former un pixel **50** capable d'afficher la couleur voulue. Sur ces figures les sous-pixels sont de couleurs rouge **51,** bleue **52** et verte **53,** et peuvent comprendre, comme sur la figure 2(c), en plus un sous-pixel blanc **54** pour augmenter la lumoinosité du pixel **50.** L'arrangement de la figure 2(a) est connue sous le sigle « RGB Stripe », c'est le plus répandu. L'arrangement de la figure 2(b) est connu sous le sigle « RGB quad », et celui de la figure 2(c) sous le sigle « RGBW quad ».

Le principe d'adressage qui vient d'être décrit en relation avec les figures 1 et 2 est l'un des principes d'adressage qui peuvent être mis en œuvre en relation avec la présente invention. La couleur peut être obtenue par le contrôle de la couleur émise par les couches OLED formant les sous-pixels ou par des filtres de couleurs qui modifient la couleur blanche de la lumière émise par les sous-pixels, comme cela sera expliqué ci-dessous en relation avec la figure 3.

La figure 3 montre de manière schématique des microafficheurs OLED selon l'état de la technique ; elle illustre le problème que la présente invention cherche à résoudre. Sur la figure 3(a) est montré une vue schématique globale de la structure du dispositif **70** : on distingue le substrat **71** (de type CMOS ou TFT, les circuits et composants d'adressage ne sont pas montrés), les électrodes de commande **72,73,74** des sous-pixels séparés par un élément de remplissage (« gap-fill ») **75,** la couche OLED **76** apte à émettre une lumière blanche, la couche d'encapsulation **77,** les filtres colorés de couleur bleue **91,** rouge **92** et verte **93** formant un pixel **90,** la tranche de verre **78** comme couverture protectrice. La taille des sous-pixels est typiquement de l'ordre de 3,5 µm à 5 µm. On note que dans ce dispositif selon l'état de la technique la couche OLED **76** s'étend sur toute la surface du dispositif.

La figure 3(b) montre une vue agrandie d'un dispositif similaire à celui représenté sur la figure 3(a) ; cette vue se limite à un seul pixel **90.** Les sous-pixels sont définis, d'une part, par les électrodes **72,73,74** qui permettent leur adressage individuel, et par les filtres colorés correspondants **91,92,93** qui modifient la lumière émise par la couche OLED **76** à émission blanche qui s'étend sur toute la surface du dispositif. L'espace entre deux électrodes de commande de sous-pixel voisines **72,73** peut être rempli par un élément de remplissage **75.** Ladite couche OLED **76** comprend la couche électroluminescente **80** proprement dite, qui est prise en sandwich entre deux couches de transport de charge **81, 82.** Plus précisément, dans un dispositif typique, la couche **81** comprend une couche d'injection et de transport de trous, et la couche **82** une couche d'injection et de transport d'électrons. Mais il est aussi possible d'utiliser un empilement dit « inverse », dans ce cas la couche **82** comprend une couche d'injection et de transport de trous, et la couche **81** une couche d'injection et de transport d'électrons. Les couches **81** et **82** peuvent comprendre respectivement une seule couche qui remplit à la fois les deux fonctions l'injection et transport des charges respectives, ou plusieurs couches, par exemple une couche pour l'injection et une autre pour le transport des charges respectives. Une électrode commune **85** évacue les charges.

Ce dispositif selon l'état de la technique présente des courants parasites ; cela est illustré sur la figure 3(b). En effet, si lors de l'allumage d'un sous-pixel (par exemple **73**) le courant principal traverse (marqué par une flèche épaisse) directement la couche OLED dans le sens le plus court (i.e. vertical par rapport au substrat **71**), une partie du courant se propage selon d'autres chemins de conduction, dans la mesure où ces chemins de conduction présentent une résistivité suffisamment faible. Ainsi on observe un courant parasite qui se propage dans la couche de transport de charges **81,** à savoir dans le plan du substrat, et qui ensuite traverse la couche OLED dans le sous-pixel voisin **72** ou **73.** Ce courant parasite est marqué par deux flèches pointillées. Il conduit à une émission lumineuse parasite dans les sous-pixels voisins, qui modifie la résolution d'image de l'afficheur et diminue la fidélité de sa couleur. La présente invention cherche à fournir un moyen pour diminuer ce courant parasite.

La figure 3(c) montre un autre dispositif de type connu dans lequel la couleur d'un pixel **90** n'est pas générée, comme dans les dispositifs des figures 3(a) et 3(b), par un élément OLED à émission blanche assorti à des filtres de couleur pour chacun des trois sous-pixels, mais par des trois sous-pixels dotés de couches électroluminescentes **95,96,97** qui émettent directement en rouge, bleu et vert. Dans ce mode de réalisation, chaque sous-pixels **95,96,97** dispose de sa propre électrode d'adressage **98a,b,c,** mais la première couche d'injection et de transport de charges **83** (par exemple des trous), et/ou la deuxième couche d'injection et de transport de charges (par exemple d'électrons) **84** et l'électrode commune **99** sont communes pour simplifier la fabrication dispositif. Le problème des courants parasites est le même que celui décrit en relation avec la figure 3(b) ; la contribution de la couche d'injection et de transport de trous **83** est prépondérante dans ces courants parasites.

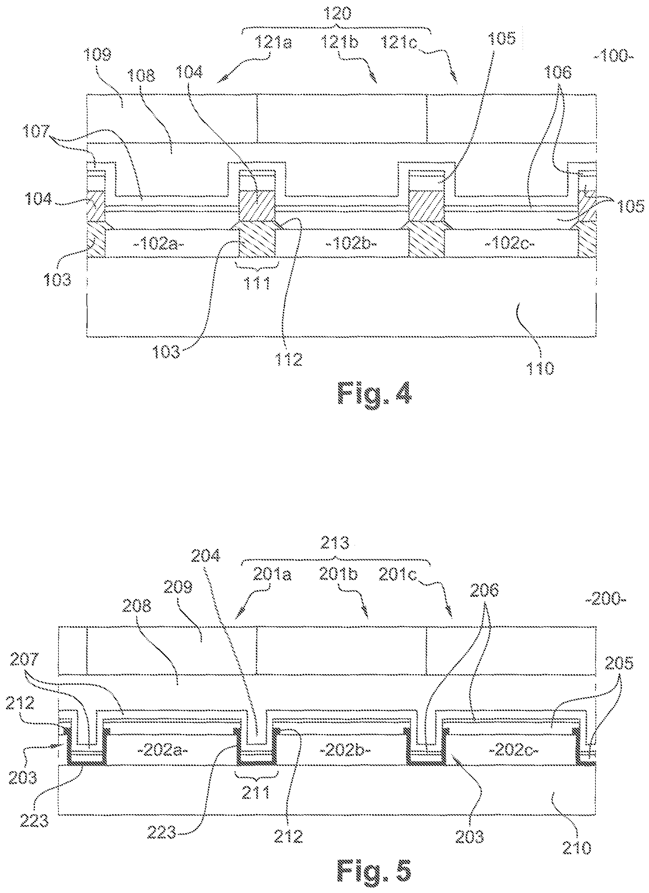

La figure 4 illustre une vue en coupe d'un dispositif **100** selon un un exemple non conforme à l'invention revendiquée.

Il comprend un substrat **110** sur lequel sont déposés trois sous-pixels **121a,121b,121c** définissant un pixel **120.** Dans cet exemple chaque sous-pixel représente une zone émettrice élémentaire.

Le substrat **110** est spécialement adapté au dispositif **100,** il peut s'agir notamment d'un substrat en silicium, en verre ou en matière plastique pour un dispositif flexible. Le substrat **110** peut notamment être un substrat silicium CMOS de type connu qui comprend les circuits d'adressage des pixels **120** et sous-pixels **121** ; ces aspects d'adressage des pixels et sous-pixels ne font pas partie de la présente invention.

Les zones émettrices élémentaires (sous-pixels) sont formées par plusieurs couches, qui seront énumérées ici en commençant par la couche déposée directement sur le substrat, qui est une électrode **102,** pour chaque sous-pixel ; ces électrodes **102** de sous-pixels sont désignés ici par les signes **102a,102b,102c.** Au-dessus de l'électrode sont déposées les couches électroluminescentes OLED formant un empilement **105,** une couche d'injection supérieure **106,** qui est optionnelle, puis une électrode conforme **107** commune. Selon le type de dispositif on peut ajouter une couche de planarisation **108** et des filtres colorés **109.** Plus précisément, la couche de planarisation est particulièrement avantageuse si des filtres colorés sont utilisés, pour éviter des pertes optiques. Même en l'absence de filtres optiques la couche de planarisation peut former la base pour un système d'encapsulation supplémentaire, qui peut comprendre par exemple une couche inorganique et/ou un capot en verre. La nécessite d'utiliser des filtres de couleur dépend de la couleur d'émission des couches OLED formant les sous-pixels, comme cela a été expliqué ci-dessus.

Deux électrodes de zone émettrice élémentaires (sous-pixels) voisines (par exemple les électrodes **102a** et **102b**), qu'elles appartiennent ou non au même pixel, sont séparés par un espace **111** dit ici espace naturel (en anglais « gap »). Selon une caractéristique essentielle de l'invention cet espace naturel **111** est rempli par un élément de remplissage à surface isolante **103** dit « gap fill ». Ledit élément de remplissage à surface isolante **103** peut chevaucher légèrement l'électrode de sous-pixel **102** pour former un rebord **112.** Dans un mode de réalisation particulier non seulement la surface de l'élément de remplissage **103** mais tout son volume est en matière isolante. Il peut être réalisé par exemple à partir d'une composition à base d'une résine photosensible (appelée aussi photorésist) ou de silice.

Un séparateur à surface isolante **104** est disposé au-dessus de l'élément de remplissage **103** à surface isolante. Ses parois peuvent être verticales. Il sépare l'empilement des couches OLED **105** et la couche d'injection supérieure **106** de deux sous-pixels **102** voisins. Dans un mode de réalisation particulier non seulement sa surface mais tout son volume est en matière isolante. Il peut être fabriqué à partir d'une résine photosensible ; on peut utiliser des résines photosensibles de type négatif qui permettent de produire des parois latérales assez raides ou même en surplomb. Des matériaux diélectriques inorganiques peuvent aussi être utilisés.

L'empilement OLED **105** est typiquement déposé par évaporation thermique. Cette technique forme un dépôt de manière très directive, et ainsi l'empilement OLED **105** se dépose fondamentalement sur les surfaces horizontales uniquement et ne se dépose pas sur les parois verticales des séparateurs. Les couches de l'empilement OLED **105** sont donc interrompues par le séparateur, autrement dit : elles sont non-continues au travers du séparateur, elles sont pixelisées.

La couche d'injection supérieure **106** pixelisée peut être remplacée par une électrode supérieure pixélisée (i.e. chaque zone d'émission élémentaire a sa propre couche d'injection supérieure ou couche électrode supérieure). Cette couche d'électrode supérieure peut être réalisée à partir d'un métal mince tel que de l'aluminium (AI), de l'argent (Ag) ou autre ; cette couche peut être déposée elle aussi par évaporation thermique, et dans ce cas elle se déposera sur les surface horizontales seulement. On note que sur les figures, cette couche d'électrode supérieure, lorsqu'elle remplace ladite couche d'injection supérieure, correspond à la couche identifiée par le repère numérique **106.**

Pour connecter la couche d'injection supérieure **106** ou l'électrode supérieure, ou la dernière couche de l'empilement OLED **105** dans le cas où aucune couche d'injection supérieure et aucune électrode pixelisée n'est déposée, de l'ensemble des pixels, il y a nécessité d'une électrode supplémentaire commune **107** qui ne soit donc pas coupée par les séparateurs **104.** Cette électrode commune **107** doit être déposée par une technique permettant un dépôt conforme. Elle peut être réalisée par la technique de dépôt atomique de couches minces (connue sous le sigle ALD, « Atomic Layer Deposition ») ou par dépôt chimique en phase vapeur (CVD, « Chemical Vapor Deposition »)) d'un oxyde conducteur transparent (TCO, « Transparent Conductive Oxyde »). Parmi les TCO qui peuvent convenir on cite le ZnO, possiblement dopé à l'aluminium (connu sous le sigle AZO (aluminium-doped zinc oxyde)), le SnO₂, l'oxyde d'indium dopé à l'étain (connu sous le sigle ITO (« Indium Tin Oxyde »)) ; ces TCO sont connus de l'homme du métier. En périphérie (non représenté sur la figure), cette électrode commune **107** est connectée à un potentiel électrique adapté pour allumer l'OLED **105** lorsque l'électrode de pixel **102** correspondante est adressée. Si on a déposé une électrode supérieure **106** par évaporation d'un métal, cette électrode sera (plus ou moins) pixelisée par les séparateurs **104,** et dans ce cas l'électrode conforme commune **107** fera le lien électrique entre les petits pavés de la couche d'injection supérieure **106.**

Dans ce mode de réalisation du dispositif **101,** les courants parasites latéraux dans l'OLED **105** sont complètement bloqués. Un autre avantage de cette architecture est que l'électrode commune conforme **107,** notamment déposée par ALD, est un film mince dense et étanche qui agit comme une encapsulation et protège l'empilement OLED **105** de l'humidité et de l'oxygène. Si un défaut se produit par exemple à travers un trou d'épingle (« pinhole » en anglais) dans l'encapsulation, et notamment un défaut qui engendre une tache noire, ce défaut ne peut pas s'étendre sur une plus grande surface, puisque le séparateur **104** et l'électrode commune **107** isolent chaque pixel (plus ou moins) hermétiquement contre la diffusion par exemple de l'eau. Ainsi, si ledit défaut ne touche qu'un sous-pixel il ne sera peut-être même pas visible par l'utilisateur du dispositif.

Le mode de réalisation de la figure 4 garde son avantage dans le cas où la paroi du séparateur **104** n'est pas complètement verticale et n'isole pas complètement les zones émettrices élémentaires voisine : cela augmente tout de même significativement la résistance latérale entre deux empilements OLED **105** voisins et diminue le phénomène de crosstalk.

Nous décrivons ici de manière plus précise les différentes couches qui forment un dispositif selon ce premier mode de réalisation ; cette description ne représente qu'un exemple et ne limite pas la portée de l'invention.

De manière connue le substrat **110** à matrice active peut être un substrat CMOS (silicium), comprenant des transistors en technologie CMOS, ou un substrat de type verre ou plastique comprenant des transistors de type TFT (typiquement en a-Si, poly-Si, oxyde métallique ou organique).

L'électrode de pixel **102** est une couche d'aluminium (AI) ou tout autre métal, d'une épaisseur typique de 20 nm à 1 000 nm, de préférence de 100 nm à 300 nm, éventuellement recouverte d'une fine couche de TiN ou MoO₃ ou d'un oxyde transparent conducteur (abrégé TCO) ou similaire. L'électrode de pixel peut être réalisée en TCO, notamment dans le mode de réalisation d'un afficheur qui émet vers le bas à travers un substrat transparent, ou dans le mode de réalisation d'un afficheur transparent qui émet vers le haut et vers le bas.

Le sous-pixel d'affichage à une dimension comprise typiquement entre 1 µm et 100 µm, de préférence entre 2 µm et 50 µm, et encore plus préférentiellement entre 2 µm et 10 µm. La distance entre les sous-pixels est de l'ordre de 0,1 µm à 10 µm, et de préférence entre 0,2 µm et 1,0 µm.

L'élément de remplissage **103** (« Gap-fill ») peut être une résine photosensible, une résine époxy, un diélectrique inorganique comme SiO₂, Si₃N₄, Al₂O₃. La largeur du recouvrement (rebord **112**) sur l'électrode est comprise entre 0 et 0,5 µm, de préférence entre 0,05 µm et 0,25 µm.

Le séparateur **104** peut être composé d'une résine photosensible, d'un époxy, d'un diélectrique inorganique comme SiO₂, Si₃N₄, Al₂O₃ etc. Sa largeur est à peu près égale à la distance entre les pixels.

L'empilement OLED **105** peut être un OLED blanc, à cellule unique ou à cellule tandem ou à cellule multiple, d'une épaisseur typiquement comprise entre 50 nm et 500 nm, et de préférence entre 80 nm et 250 nm. L'empilement OLED **105** peut émettre en haut ou en bas, ou émettre sur deux faces. Le dépôt de couches de l'empilement OLED **105** est réalisé par une méthode directive comme par exemple évaporation thermique.

La couche d'injection supérieure **106** (ou, le cas échéant, l'électrode supérieure) est déposée dans l'espace entre deux séparateurs **104** voisins. Si une électrode supérieure est déposée, elle peut être réalisée en métal réfléchissant comme l'aluminium (AI) ou l'argent (Ag), dont l'épaisseur est typiquement de 25 nm à 100 nm pour l'émission du fond, de 1 nm à 15 nm pour l'émission supérieure ou les deux côtés. Le dépôt peut être réalisé par une méthode directive comme par exemple l'évaporation thermique.

L'électrode commune **107,** déposée au-dessus de la couche d'injection supérieure **106** ou de l'électrode supérieure (si l'une de ces dernières est présente) ou au-dessus de l'empilement OLED **105** dans le cas contraire, est typiquement un oxyde conducteur transparent comme par exemple ZnO, AZO, ITO, SnO₂ ou autre. Elle est déposée par une méthode de dépôt hautement conforme comme ALD, PECVD ou autre. Son épaisseur est typiquement comprise entre 20 nm et 300 nm.

La couche de planarisation (couche de lissage) **108** est typiquement une matière organique (telle qu'une résine photosensible ou une résine époxy) déposée à partir d'une solution (par spin coating ou spray-coating ou similaire).

Le filtre de couleur **109** est un filtre de couleur de l'état de l'art, réalisé par des résines colorées par exemple. Il peut être fait à partir de résine photosensible colorée, ou à partir de filtres d'interférence à motifs, ou similaire.

Un mode de réalisation d'un dispositif selon l'invention est illustré sur la figure 5.

L'architecture reprend la plupart des composants présentés en relation avec le premier mode de réalisation ; la figure montre trois zones émettrices élémentaires **201a,201b,201c** qui forment un pixel **213.** Le dispositif **200,** présenté par une vue en coupe, comprend un substrat **210** et des électrodes **202** de sous-pixels séparées par un espace naturel **211** qui a la forme d'une tranchée. Une couche d'isolation **223** est disposée dans cet espace naturel **211,** et plus précisément sur ses parois, avec un rebord **212** (chevauchement) sur les pixels d'électrode **202.** Elle joue le rôle de d'élément de remplissage à surface isolante **203.**

Les couches électroluminescentes **205** OLED formant un empilement sont déposées sur l'électrode de sous-pixels **202** et sur ladite couche d'isolation **223,** puis une couche d'injection supérieure **206** ou une électrode supérieure (la première est préférée, mais les deux sont optionnelles), une électrode conforme **207,** une couche de planarisation (appelée aussi couche de lissage) **208** qui est optionnelle et qui joue le rôle de séparateur **204,** et des filtres colorés **209.** En l'absence de couche de lissage **208** l'espace naturel peut rester vide au-dessus de l'électrode commune **207,** ce vide jouant le rôle de séparateur **204,** ou il peut être rempli par des éléments du système d'encapsulation.

Ce mode de réalisation permet d'utiliser l'espace naturel entre les électrodes de sous-pixels **202,** qui ont des parois verticales, comme séparateur. Comme les parois des électrodes de sous-pixels **202** sont conductrices, elles doivent être recouvertes d'une couche d'isolation **223 ;** cette dernière peut recouvrir légèrement le bord du pixel d'électrode **202,** ce qui diminue le risque de courts-circuits, mais augmente la complexité du procédé de fabrication. Ladite couche d'isolation **223** peut être une couche mince diélectrique, par exemple une couche d'alumine, de silice ou similaire, déposée par un procédé de dépôt conforme comme un ALD, PECVD, ou similaire. On peut utiliser une couche organique, par exemple une fine couche de résine photosensible ; elle peut typiquement être réalisée par photolithographie, en laissant un léger retour (chevauchement) comme indiqué sur la figure 4 afin d'éviter les courts-circuits sur le bord.

Nous décrivons ici de manière plus précise les différentes couches qui forment un dispositif selon ce deuxième mode de réalisation ; cette description ne représente qu'un exemple et ne limite pas la portée de l'invention.

Le substrat **200,** l'électrode de pixel **202,** l'empilement OLED **205,** l'électrode commune **220** optionnelle, l'électrode conforme **207,** la couche de planarisation **208** optionnelle, le filtre couleur **209** reprennent les compositions du premier mode de réalisation.

On dépose au-dessus de l'électrode de pixel **202** une fine couche (non montrée sur la figure) d'un matériau conducteur capable d'injecter des porteurs de charge (électrons ou trous, selon la géométrie du dispositif OLED) dans une couche organique pour OLED. Cette fine couche protège la surface du pixel lors de la gravure de la couche isolante **223.** Son épaisseur est comprise entre 1 nm et 50 nm, et de préférence entre 5 nm et 15 nm. Ladite fine couche peut être en TiN, ou encore, et de manière préférée, en un oxyde transparent conducteur (notamment : oxyde d'étain (SnO₂), oxyde d'indium dopé à l'étain (ITO), oxyde de zinc (ZnO), oxyde de zinc dopé à l'aluminium (AZO)). Si ladite gravure de la couche isolante **223** fait intervenir un plasma à l'oxygène, on préfère que ladite fine couche soit en oxyde.

Pour réaliser la couche d'isolant **223,** une fine couche de TiO₂ (épaisseur typiquement comprise entre 5 nm et 20 nm) peut être déposée par ALD sur toute la surface du substrat. Ensuite on dépose une couche de polymère photosensible de type connu (par exemple TEKR-003PM) par spin-coating ; l'épaisseur peut être comprise entre 0,5 µm et 1 µm pour la référence indiquée. On délimite ensuite la surface active des pixels par photolithographie ; avec un petit recouvrement (typiquement entre 0,1 µm et 0,2 µm) à la frontière des pixels. Ensuite on enlève le TiO₂ par gravure humide en utilisant du HF ; cela n'attaque pas la couche de TiN qui protège ainsi l'électrode de pixel. Ce choix de matériau (TiO₂ sur TiN) est un moyen essentiel pour réussir la mise en œuvre de ce mode de réalisation de l'invention. On enlève ensuite la couche de polymère photosensible pour ouvrir l'espacement entre pixels. La partie restante de la couche TiO₂ forme ainsi la couche d'isolant **223.**

Dans un autre mode de réalisation, on peut avantageusement utliser pour la couche isolante **223** un autre matériau isolant comme l'oxyde d'aluminium, l'oxyde de silicium, le nitrure de silicium, déposé de manière conforme par ALD ou par CVD. Au lieu d'une gravure humide de cette couche, on peut utiliser des techniques gravure sèche et notamment une gravure sèche réactive (RIE).

Ensuite, on dépose les couches organiques pour former la diode OLED, ainsi que la cathode. On obtient ainsi la structure indiquée, dans laquelle les pixels sont séparés par une tranchée, et les parois de cette tranchée sont isolées par la couche isolante **223.**

Ladite tranchée peut éventuellement d'étendre dans le substrat **210,** notamment si sa réalisation implique une étape de gravure.

Autre que en TiO₂, la couche d'isolation **223** peut être une couche mince diélectrique fait d'un autre matériau, par exemple en Al₂O₃, de SiO₂, de Si₃N₄, ou similaire, déposée par ALD, PECVD, ou similaire. L'épaisseur de la couche est typiquement de l'ordre de 5 nm à 25 nm, modelée par photolithographie.

L'électrode supérieure, qui est optionnelle, peut être réalisée sous forme d'une très fine couche d'argent ou d'aluminium d'une épaisseur entre 4 nm et 10 nm. Si elle est absente, c'est l'électrode commune **207** qui remplit alors la fonction d'électrode pour chaque zone émettrice élémentaire. Dans ce cas, entre deux séparateurs voisins, et délimitée par ces derniers, s'étend avantageusement une couche d'injection **206** de porteurs de charge en un matériau capable d'injecter des porteurs de charge dans l'empilement OLED ; on peut utiliser de l'oxyde de molybdène ou de l'oxyde de tungstène. La couche peut avoir une épaisseur typiquement comprise entre 0,5 nm et 5 nm.

La présente invention s'applique indifféremment au cas où les zones émettrices élémentaires sont des pixels ou des sous-pixels, et au cas où elles émettent une lumière blanche ou de couleur ; la présence de filtres colorés **109** est nécessaire pour permettre l'affichage de sous-pixels en couleur si les couches OLED desdits sous-pixels émettent tous de la lumière blanche.

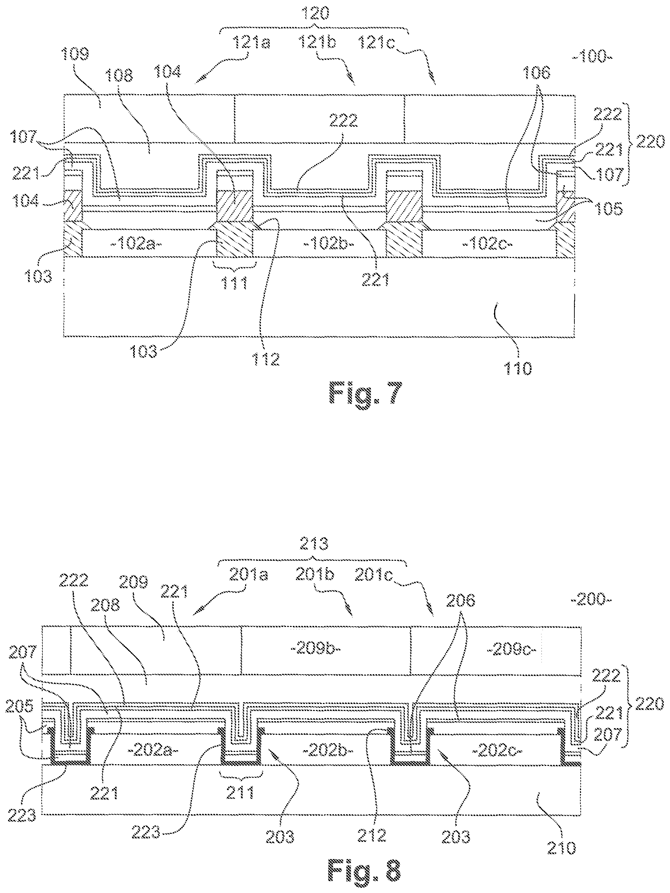

Il convient de noter que dans un souci de simplification ni la figure 4 ni la figure 5 ne montrent le système d'encapsulation du dispositif. Le système d'encapsulation peut comprendre, de manière connue des document US 8,693,396 ou US 9,082,999) un complexe tricouche alumine / polymère / alumine. La couche de lissage **108** peut etre déposée au-dessus de la dernière couche de système tri-couche. La présente invention permet, dans une variante, de simplifier ce système d'encapsulation en utilisant l'électrode conforme commune **107** comme la première couche de complexe tricouche. Cette variante est montrée sur la figure 7 (variante du dispositif de la figure 4) et sur la figure 8 (variante de la figure 5), où les repères **220,221** et **222** désignent, respectivement, le système d'encapsulation, la couche de polymère et la couche d'oxyde, cette dernière pouvant être en particulier la silice ou l'alumine. La couche de lissage **108** se trouve alors au-dessus de la dernière couche d'encapsulation, en l'occurrence la couche d'oxyde **222.** On note que l'électrode conforme commune **107** agit comme barrière pour l'atmosphère ambiante et protège les couches sous-jacentes. Elle peut représenter à elle seule le système d'encapsulation (sachant que la couche de lissage et éventuellement le filtre coloré agissent comme protection mécanique), même si cela n'est pas le mode de réalisation préféré.

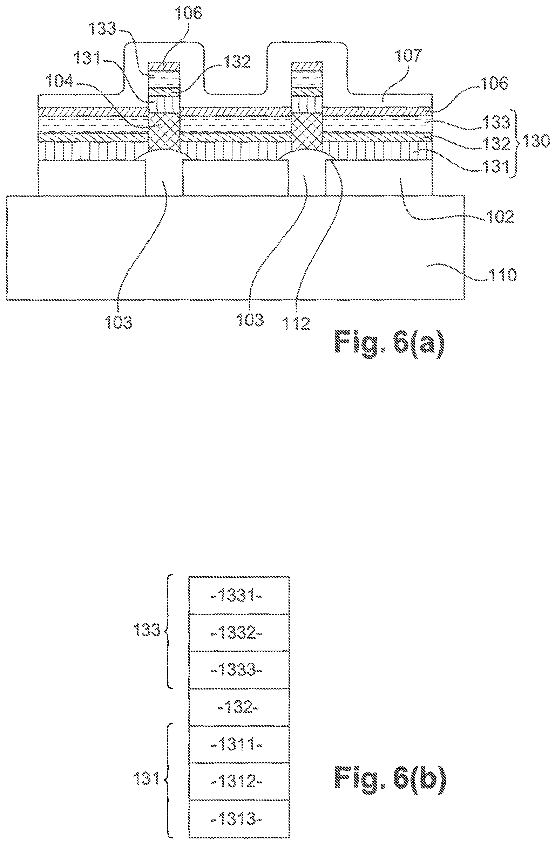

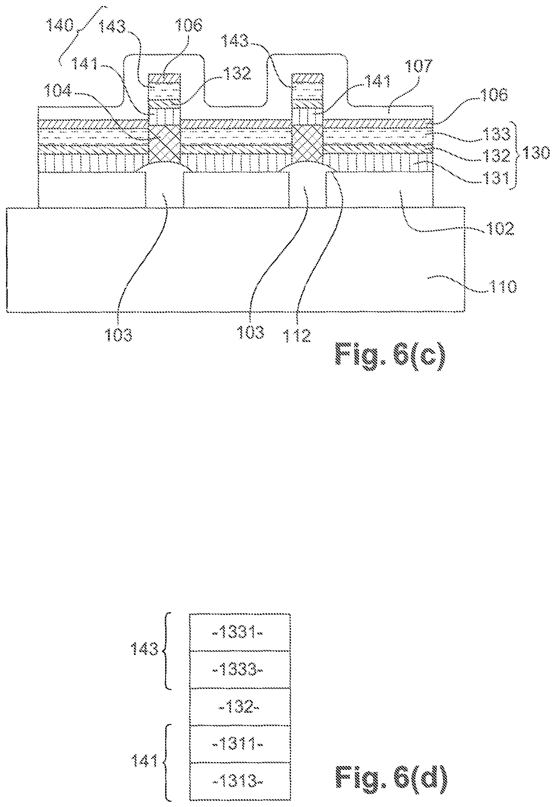

Nous décrivons ici en relation avec la figure 6 un un autre exemple non conforme à l'invention revendiquée, avec une structure du dispositif OLED de type tandem. La figure 6(a) montre un tel dispositif **130** qui se caractérise par la superposition de deux empilements OLED **131, 133** qui sont séparées par une couche de génération de charges **132.** Pour la structure de l'élément de remplissage à surface isolante **103** et le séparateur à surface isolante **104** le dispositif suit le premier mode de réalisation décrit ci-dessus. Sur cette figure ne figurent pas la couche de lissage et les filtres de couleur, qui sont optionnelles, en fonction de la couleur émise par les zones émettrices élémentaires formant les pixels, ni la couche d'encapsulation.

La figure 6(b) montre en plus grand détail l'empilement des couches formant les empilements OLED. Le premier **131** et le deuxième **133** empilement OLED comprennent chacun sa couche d'injection et de transport d'électrons **1311,1331,** qui injecte des électrons dans la couche électroluminescente **1312, 1332,** et sa couche d'injection et de transport de trous **1313, 1333,** qui injecte des trous dans ladite couche électroluminescente **1312,1332.** La couche d'injection et de transport d'électrons **1311** du premier empilement OLED **131** et la couche d'injection et de transport de trous **1333** du deuxième empilement OLED **133** sont séparées par une couche de génération de charges **132.** Dans une variante (non illustrée sur les figures) l'ordre des couches peut être inversé, et ainsi la couche d'injection et de transport d'électrons peut se trouver en dessous de la couche électroluminescente respective et la couches d'injection et de transport de trous au-dessus de la couche électroluminescente respective.

Dans une variante avantageuse illustrée sur la figure 6(c) la couche électroluminescente **1312,1332** (montrée sur la figure 6(b) uniquement) est structurée, c'est-à-dire elle est déposée uniquement sur les zones émettrices élémentaires à l'exclusion des zones occupées par les éléments de remplissage à surface isolante et du séparateur. Un tel dépôt structuré peut être obtenu à l'aide d'un pochoir ; c'est une technique connue en tant que telle. Dans cette variante, seules la couche d'injection et de transport de trous **1313,1333** et/ou la couche d'injection et de transport d'électrons **1311,1331** sont déposées sur toute la surface de l'afficheur, y compris sur la zone occupée par les éléments de remplissage à surface isolante et le séparateur. Dans cette zone on obtient un empilement **141,143** qui est schématiquement représenté sur la figure 6(d) : ce n'est pas un « empilement OLED » car il ne comprend pas la couche électroluminescente et n'émet donc pas de lumière. Cependant, sans la présence de l'élément séparateur à surface isolante, un courant parasite passerait à travers ces couches d'injection et de transport, qui contribuerait au phénomène de cross-talk que la présente invention vise à éliminer. Il serait en principe possible de déposer également la couche d'injection et de transport de trous **1313,1333** et la couche d'injection et de transport d'électrons **1311,1331** en utilisant la technique du pochoir, mais cela augmente le temps du process, risque de diminuer le rendement industriel, et engendrerait ainsi un surcoût inacceptable.

### Exemples

Les exemples ci-dessous ne sont pas conformes à l'invention revendiquée.

Ces exemples portent sur deux modes de réalisation et sur les matériaux usités pour réaliser les structures correspondantes des différents modes de réalisation.

On a réalisé des micro-afficheurs OLED présentant une matrice de 1280 x 1024 pixels, avec 4 sous-pixels par pixel, dans un arrangement de type « RGBW quad » selon la figure 2(c). La taille des pixels était de 9,4 µm x 9,4 µm, la taille des sous-pixels de 4,7 µm x 4,7 µm. On a utilisé des pixels blancs, colorés par des filtres de couleur. La dimension totale de l'écran d'affichage du micro-afficheur « était de 12,03 mm x 9,63 mm.

On a déposé sur un substrat **110** silicium de diamètre 200 mm à matrice active (technologie CMOS) les circuits pour la matrice de pixels comportant 2560 x 2048 sous-pixels. La couche d'électrode **102** de pixels était en aluminium, avec une dimension de 3,7 µm x 3,7 µm. Une couche d'oxyde de silicium a été déposée et structurée par photolithographie pour générer le gap-fill. (On peut également déposer un vernis photorésist ou un polymère réticulable, qui est ensuite structuré). Au-dessus du gap-fill on dépose ensuite un séparateur organique (en déposant et structurant un photorésist négatif ou un autre type de vernis réticulable). Alternativement on peut fabriquer le séparateur par le dépôt et la structuration d'un matériau inorganique (tel que Al₂O₃ ou SiO₂) en utilisant une gravure anisotrope).

Sur cet ensemble est déposé un empilement de couches OLED (lumière blanche) par évaporation thermique à travers des masques (pour limiter le dépôt à la surface des pixels individuels), avec les particularités suivantes :
- Au lieu d'une cathode standard, de type métal semi-transparent, on dépose une couche d'injection d'électrons **106** en oxyde de molybdène d'une épaisseur compris entre 0.5 et 5nm par évaporation thermique.
- Au-dessus de la couche de MoO3, on dépose une couche de TCO (telle que AZO, ZnO ou SnO₂) par ALD ; ce dépôt couvre les connexions électriques de la cathode mentionnés ci-dessus. L'épaisseur est comprise entre 25 nm et 300 nm.

On peut ajouter une encapsulation en couches minces au-dessus de la couche de TCO, mais cette dernière peut également remplir seule la fonction d'une couche d'encapsulation. Au-dessus de cet ensemble on dépose (de préférence sur une couche de lissage déposée au-dessus du système d'encapsulation) les filtres colorés et éventuellement une couverture en verre ou d'autres moyens pour protéger l'écran du micro-afficheur. Ensuite, la tranche de silicium est découpée pour libérer les micro-afficheurs qui peuvent être intégrés dans des dispositifs électroniques plus complexes.

## Revendications

1. Dispositif d'affichage électroluminescent (200) comprenant une pluralité de pixels (213) déposés sur un substrat (210), chaque pixel étant formé d'une ou plusieurs zones émettrices élémentaires (201a,b,c), chaque zone émettrice élémentaire comportant une électrode de base (202a,b,c) déposée sur ledit substrat (210) et un empilement OLED (205) comprenant une couche électroluminescente déposée sur ladite électrode de base (202a,b,c), et ledit dispositif (200) comprenant une électrode commune (207) déposée au-dessus dudit empilement OLED par une technique de dépôt conforme telle que ALD (Atomic Layer Deposition) ou CVD (Chemical Vapor Deposition), ledit dispositif étant **caractérisé en ce que** :
- Deux électrodes de base (202a,202b) voisines appartenant à deux zones émettrices élémentaires (201a,201b) voisines sont séparées par un espace naturel (211) qui a la forme d'une tranchée et qui agit comme séparateur de deux électrodes de base (202a,202b) voisines,
- Une couche d'isolation (223) est disposée dans ledit espace naturel (211) et sur les parois des électrodes de base (202a,202b),
- Les couches de l'empilement OLED (205) sont déposées sur ladite électrode de base (202a,b,c) et sur ladite couche d'isolation (223) entre lesdites électrodes de base 202a,b,c), et sont interrompues par le séparateur (204) ;
- Une électrode commune (107, 207) conforme est déposée au-dessus de l'empilement OLED et de l'espace naturel (211).

2. Dispositif selon la revendication 1, **caractérisé en ce que** ledit substrat (210) est un substrat à matrice active, tel qu'un substrat de type CMOS en silicium ou un substrat de type verre ou plastique comprenant des transistors de type TFT.

3. Dispositif selon l'une quelconque des revendications 1 à 2, **caractérisé en ce que** ladite couche d'isolation (223) déborde sur une partie de la surface desdites électrodes de base (202a,202b).

4. Dispositif selon l'une quelconque des revendications 1 à 3, **caractérisé en ce qu'**entre deux séparateurs (204) voisins, et délimitée par ces derniers, s'étend une couche transparente conductrice capable d'injecter des porteurs de charge dans l'empilement OLED, déposée entre ledit empilement OLED (205) et ladite électrode commune (207), l'épaisseur de ladite couche transparente conductrice étant de préférence comprise entre 0,5 nm et 5 nm.

5. Dispositif selon la revendication 4, **caractérisé en ce que** ladite couche transparente conductrice a été déposée par une technique de dépôt directive, telle que l'évaporation thermique.

6. Dispositif selon la revendication 4 ou 5, **caractérisé en ce que** ladite couche transparente conductrice est un oxyde de molybdène ou un oxyde de tungstène

7. Dispositif selon l'une quelconque des revendications 1 à 6, **caractérisé en ce qu'**entre deux séparateurs (204) voisins, et délimitée par ces derniers, s'étend une électrode supérieure d'une épaisseur entre 4 nm et 10 nm et déposée par une technique de dépôt directive, telle que l'évaporation thermique, ladite couche d'électrode supérieure étant réalisée de préférence à partir d'un métal mince tel que de l'aluminium (AI) ou de l'argent (Ag).

8. Dispositif selon l'une quelconque des revendications 1 à 7, **caractérisé en ce qu'**il comprend un système d'encapsulation (220) déposé au-dessus de l'électrode commune (207).

9. Dispositif selon la revendication 8, **caractérisé en ce que** ledit système d'encapsulation (220) comprend une couche de polymère (221) et une couche inorganique, de préférence un oxyde (222).

10. Dispositif selon la revendication 9, **caractérisé en ce qu'**il comprend une couche inorganique, de préférence un oxyde, déposée entre l'électrode commune (207) et la couche de polymère (221).

11. Dispositif selon l'une quelconque des revendications 1 à 10, **caractérisé en ce qu'**il comprend une couche de lissage (108,208) déposée, soit au-dessus de ladite électrode commune (107,207), soit au-dessus dudit système d'encapsulation (220).

12. Dispositif selon l'une quelconque des revendications 1 à 11, **caractérisé en ce qu'**il comprend un système de filtres colorés (209), déposé sur l'électrode commune (207), ou de préférence sur le système d'encapsulation (220), ou encore plus préférentiellement sur ladite couche de lissage (208).

13. Dispositif selon l'une quelconque des revendications 1 à 12, **caractérisé en ce qu'**il comprend deux empilements OLED superposés.

14. Dispositif selon la revendication 13, **caractérisé en ce que** les deux empilements OLED sont séparés par une couche de génération de charges.

## Patentansprüche

1. Eine elektrolumineszierende Anzeigevorrichtung (200) mit eine Mehrzahl von Pixeln (213) auf einem Substrat (210), wobei jedes Pixel aus einer oder mehreren emittierenden Elementarzonen (201a, b, c) besteht, wobei jede emittierende Elementarzone eine auf dem Substrat (210) aufgebrachte Basiselektrode (202a, b, c) und einen OLED-Stapel (205) mit einer auf der Basiselektrode (202a, b, c) aufgebrachten Elektrolumineszenzschicht umfasst, und wobei die Vorrichtung (200) eine gemeinsame Elektrode (207) umfasst, die über dem OLED-Stapel mittels eines konformen Abscheidungsverfahrens wie ALD (Atomlagenabscheidung) oder CVD (Chemische Gasphasenabscheidung) aufgebracht ist, und wobei die Vorrichtung **dadurch gekennzeichnet ist, dass**:
- zwei benachbarte Basiselektroden (202a, 202b) zweier benachbarter emittierender Elementarzonen (201a, 201b) durch einen natürlichen, grabenförmigen Spalt (211) getrennt sind, der als Separator zwischen zwei benachbarten Basiselektroden (202a, 202b) dient,
- eine Isolierschicht (223) im natürlichen Spalt (211) und auf den Wänden der Basiselektroden (202a, 202b) angeordnet ist,
- die Schichten des OLED-Stapels (205) auf den Basiselektroden (202a, b, c) und auf der Isolierschicht (223) zwischen den Basiselektroden (202a, b, c) aufgebracht sind und durch den Separator (204) unterbrochen werden,
- eine konforme gemeinsame Elektrode (107, 207) über dem OLED-Stapel und dem natürlichen Spalt (211) aufgebracht ist.

2. Vorrichtung nach Anspruch 1, **dadurch gekennzeichnet, dass** das Substrat (210) ein Aktivmatrix-Substrat ist, beispielsweise ein Silizium-CMOS-Substrat oder ein Glas- oder Kunststoffsubstrat mit TFT-Transistoren.

3. Vorrichtung nach einem der Ansprüche 1 oder 2, **dadurch gekennzeichnet, dass** sich die Isolierschicht (223) über einen Teil der Oberfläche der Basiselektroden (202a, 202b) erstreckt.

4. Vorrichtung nach einem der Ansprüche 1 bis 3, **dadurch gekennzeichnet, dass** eine transparente leitfähige Schicht, die Ladungsträger in den OLED-Stapel injizieren kann, zwischen dem OLED-Stapel (205) und der gemeinsamen Elektrode (207) abgeschieden ist, sich zwischen zwei benachbarten Separatoren (204) erstreckt und von diesen begrenzt wird, wobei die Dicke der transparenten leitfähigen Schicht vorzugsweise zwischen 0,5 nm und 5 nm liegt.

5. Vorrichtung nach Anspruch 4, **dadurch gekennzeichnet, dass** die transparente leitfähige Schicht mittels eines gerichteten Abscheidungsverfahrens, wie z. B. thermischer Verdampfung, abgeschieden wurde.

6. Vorrichtung nach Anspruch 4 oder 5, **dadurch gekennzeichnet, dass** die transparente leitfähige Schicht aus Molybdänoxid oder Wolframoxid besteht.

7. Vorrichtung nach einem der Ansprüche 1 bis 6, **dadurch gekennzeichnet, dass** sich zwischen zwei benachbarten Separatoren (204) eine obere Elektrode mit einer Dicke zwischen 4 nm und 10 nm erstreckt, die mittels eines gerichteten Abscheidungsverfahrens, wie z. B. thermischer Verdampfung, aufgebracht ist und von diesen begrenzt wird, wobei die obere Elektrodenschicht vorzugsweise aus einem dünnen Metall wie Aluminium (Al) oder Silber (Ag) besteht.

8. Vorrichtung nach einem der Ansprüche 1 bis 7, **dadurch gekennzeichnet, dass** sie ein Verkapselungssystem (220) umfasst, das über der gemeinsamen Elektrode (207) aufgebracht ist.

9. Vorrichtung nach Anspruch 8, **dadurch gekennzeichnet, dass** das Verkapselungssystem (220) eine Polymerschicht (221) und eine anorganische Schicht, vorzugsweise ein Oxid (222), umfasst.

10. Vorrichtung nach Anspruch 9, **dadurch gekennzeichnet, dass** sie eine anorganische Schicht, vorzugsweise ein Oxid, umfasst, die zwischen der gemeinsamen Elektrode (207) und der Polymerschicht (221) aufgebracht ist.

11. Vorrichtung nach einem der Ansprüche 1 bis 10, **dadurch gekennzeichnet, dass** sie eine Glättungsschicht (108, 208) umfasst, die entweder über der gemeinsamen Elektrode (107, 207) oder über dem Verkapselungssystem (220) aufgebracht ist.

12. Vorrichtung nach einem der Ansprüche 1 bis 11, **dadurch gekennzeichnet, dass** sie ein Farbfiltersystem (209) umfasst, das auf der gemeinsamen Elektrode (207) oder vorzugsweise auf dem Verkapselungssystem (220) oder besonders bevorzugt auf der Glättungsschicht (208) aufgebracht ist.

13. Vorrichtung nach einem der Ansprüche 1 bis 12, **dadurch gekennzeichnet, dass** sie zwei übereinanderliegende OLED-Stapel umfasst.

14. Vorrichtung nach Anspruch 13, **dadurch gekennzeichnet, dass** die beiden OLED-Stapel durch eine Ladungserzeugungsschicht getrennt sind.

## Claims

1. An electroluminescent display device (200) comprising a plurality of pixels (213) deposited on a substrate (210), each pixel being formed of one or more elementary emitting zones (201a, b, c), each elementary emitting zone comprising a base electrode (202a, b, c) deposited on said substrate (210) and an OLED stack (205) comprising an electroluminescent layer deposited on said base electrode (202a, b, c), and said device (200) comprising a common electrode (207) deposited above said OLED stack by a conformal deposition technique such as ALD (Atomic Layer Deposition) or CVD (Chemical Vapor Deposition), said device being **characterized in that**:
- Two adjacent base electrodes (202a, 202b) belonging to two adjacent elementary emitting zones (201a, 201b) are separated by a natural gap (211) which has the shaped of a trench and acts as a separator between two adjacent base electrodes (202a, 202b),
- An insulating layer (223) is disposed in said natural gap (211) and on the walls of the base electrodes (202a, 202b),
- The layers of the OLED stack (205) are deposited on said base electrode (202a, b, c) and on said insulating layer (223) between said base electrodes (202a, b, c), and are interrupted by the separator (204);
- A conformal common electrode (107, 207) is deposited above the OLED stack and the natural gap (211).

2. Device according to claim 1, **characterized in that** said substrate (210) is an active matrix substrate, such as a silicon CMOS type substrate or a glass or plastic type substrate comprising TFT type transistors.

3. A device according to any one of claims 1 to 2, **characterized in that** said insulating layer (223) extends over a portion of the surface of said base electrodes (202a, 202b).

4. A device according to any one of claims 1 to 3, **characterized in that** a transparent conductive layer capable of injecting charge carriers into the OLED stack, deposited between said OLED stack (205) and said common electrode (207), extends between two adjacent separators (204) and is delimited by them, the thickness of said transparent conductive layer preferably being between 0.5 nm and 5 nm.

5. A device according to claim 4, **characterized in that** said transparent conductive layer was deposited by a directional deposition technique, such as thermal evaporation.

6. Device according to claim 4 or 5, **characterized in that** said transparent conductive layer is a molybdenum oxide or a tungsten oxide

7. A device according to any one of claims 1 to 6, **characterized in that** between two adjacent separators (204), and delimited by them, extends an upper electrode with a thickness between 4 nm and 10 nm, deposited by a directional deposition technique, such as thermal evaporation, said upper electrode layer preferably being made from a thin metal such as aluminum (Al) or silver (Ag).

8. A device according to any one of claims 1 to 7, **characterized in that** it comprises an encapsulation system (220) deposited above the common electrode (207).

9. A device according to claim 8, **characterized in that** said encapsulation system (220) comprises a polymer layer (221) and an inorganic layer, preferably an oxide (222).

10. A device according to claim 9, **characterized in that** it comprises an inorganic layer, preferably an oxide, deposited between the common electrode (207) and the polymer layer (221).

11. A device according to any one of claims 1 to 10, **characterized in that** it comprises a smoothing layer (108, 208) deposited either above said common electrode (107, 207) or above said encapsulation system (220).

12. A device according to any one of claims 1 to 11, **characterized in that** it comprises a colored filter system (209) deposited on the common electrode (207), or preferably on the encapsulation system (220), or more preferably on said smoothing layer (208).

13. A device according to any one of claims 1 to 12, **characterized in that** it comprises two superimposed OLED stacks.

14. A device according to claim 13, **characterized in that** the two OLED stacks are separated by a charge generation layer.
